# EUROPEAN PATENT APPLICATION

(11) **EP 1 225 632 A1**
(43) Date of publication of application: **24.07.2002**
(21) Application number: 01101470.1
(22) Date of filing: 23.01.2001
(51) Int. Cl.: H01L 23/467

(54) **Computer heat dissipater structure**

(71) Applicant: Wei, Wen-Chen, Taipei Hsien (TW)
(72) Inventor: Wei, Wen-Chen, Taipei Hsien (TW)
(74) Representative: Zeitler, Giselher, Dipl.-Ing.

(57) **Abstract**

An improved computer heat dissipation structure, mainly comprises of a heat dissipation base with four sides folded upwards from the base plate to form four side walls with a receiving slot at the center; air outlets set respectively on the four side walls; the base plate connected with the air outlets being cut respectively with proper width and folded upwards to form a plurality of conduct current partitions; the cut planes of the conduct current partitions in different angles according to the direction of the wind thus to make the air current inducted by the fan to rapidly diffuse the heat sources absorbed by the base plate towards the air outlets through the wind channels formed by the interference of the conduct current partitions.

## Description

### BACKGROUND OF THE INVENTION

### 1) FIELD OF THE INVENTION

The invention herein relates to an improved computer heat dissipater structure, more specially a heat dissipation base with conduct current partitions in different angles and cut along the edges of the heat dissipation base to form ventilation channels, through which the heat sources can be diffused rapidly towards the air outlets for efficiently lowering the temperature.

### 2) DESCRIPTION OF THE PRIOR ART

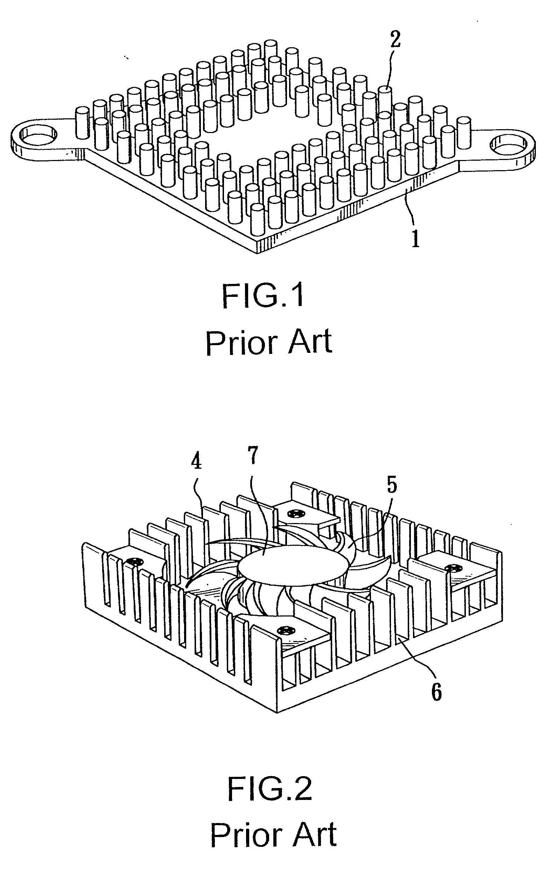

As is widely known, in order to solve the overheating problem of the components inside the computer central processing unit, a heat dissipation device is usually added to the heat sources to enable the high temperature produced by the electric components to be conducted by the heat dissipation device. However, the conventional heat dissipation devices currently available, as indicated in FIG. 1, comprise of the heat sink poles (2) mounted on the base plate (1) of the heat dissipation device, wherein the base plate (1) tightly pressed against the electric heat generating components, thereby the high temperature produced by the electric heat generating components during operation can be diffused through the heat sink poles (2). Although the production cost of this type of heat sink dissipater is lower, the rate of heat conduction speed is slower and only suitable for computer operating in lower speed. Therefore, the limited heat dissipation efficiency of this type is not ideal for the electric heat generating components required for rapid or long execution time. Another heat dissipater with a fan, as indicated in FIG. 2, mainly comprises a fan (5) added to the concaved receiving slot formed at the center of the heat sink fins (4), wherein the four sides of the heat sink fins (4) have grooved intervals as the hot air outlets (6). After being installed on the surface of electric heat generating components, the fan starts to turn and induct the outside cool air to blow on the heat sink fins to diffuse the updraft heat from the electric components through the hot air outlets (6) to achieve heat dissipation function. However, since the internal end surfaces of the hot air outlets (6) are plane and vertical, they will interference the fan current as the vent wall to easily create a standstill layer and cumulate the hot sources among the heat sink fins and the fan, only consuming the fan power but not increasing the heat dissipation function.

In view of the various shortcomings of conventional heat dissipation devices, the inventor of the invention herein, based on expertise and experience, addressed the said shortcomings by continuous studying and researching solutions for improvement and innovation which, finally culminated in the development of the improved computer heat dissipation structure.

### SUMMARY OF THE INVENTION

Specifically, the improved computer heat dissipation structure of the invention herein consists of a square concaved slot of heat dissipation base with four side walls formed by folding the four sides of the heat dissipation base plate upwards to make the center a receiving slot for mounting the fan; air outlets set respectively on the four side walls on the heat dissipation base; the place where the air outlets connected with the base plate has been cut and folded upwards respectively with proper width to form a plurality of conduct current partitions; the conduct current partitions are cut according to the direction of the turning fan into different angles to form adequate vent channels for destroying the whirling vent wall caused by the interference of the conduct current when the air current is induced by the fan, thus to avoid the phenomenon of the reverse current produced by the reflection and collision of the air current; furthermore, the formed included angles can reduce the area of the flowing field and enable the air current induced through the fan can be quickly and continuously circulated by the conduction of the conduct current partitions without causing standstill layer; furthermore, the hot sources absorbed by the base plate can be diffused rapidly towards the air outlets through the vent channels formed by the conduct current partitions, thus to fully achieve the power of the fan, the best function of heat dissipation and specifically solve the overheating problem of the computer components.

Therefore, the primary objective of the invention herein is to solve the problem of the limited heat dissipation efficiency of the conventional computer heat dissipater structure by utilizing a plurality of conduct current partitions formed by cutting and folding upwards the base plate connected with the air outlet; the cut planes of the conduct current partitions facing certain angles respectively according to the directions of the wind to form proper wind channels for the air current induced through the fan to be circulated rapidly and smoothly by the conduction of the conduct current partitions without causing the situation of standstill but at the same time quickly diffusing the hot sources absorbed by the base plate towards the air outlets through the wind channels to achieve the maximum heat dissipation efficiency.

To enable a further understanding of the said objectives, the technological methods, and specific structural features of the invention herein, the brief description of the drawings below is followed by the detail description for additional elaboration.

### BRIEF DESCRIPTION OF THE DRAWINGS

Figure 1 is a pictorial drawing of a conventional heat dissipation device.
Figure 2 is a pictorial drawing of another conventional heat dissipation device.
Figure 3 is a pictorial drawing of the disassembled invention herein.
Figure 4 is a pictorial drawing of the assembled invention herein.
Figure 5 is an isometric drawing of wind conduction of the invention herein.
Figure 6 is another isometric drawing of the invention herein in preferred embodiment.

### DETAILED DESCRIPTION OF THE INVENTION

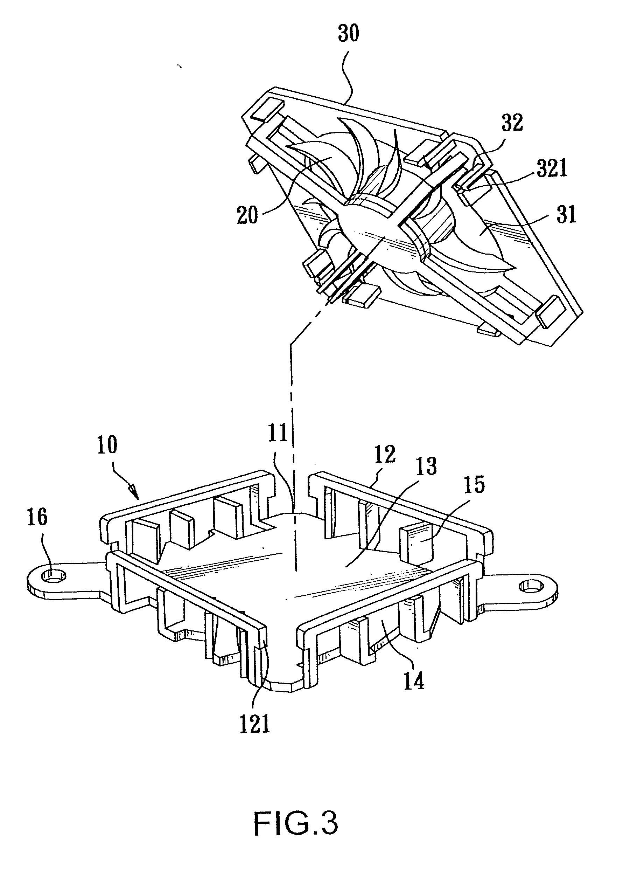

Referring to FIG. 3, the pictorial drawing of the disassembled invention herein, mainly includes a heat dissipation base (10), a fan (20) and a cover (30); furthermore, protruded mounting holes (16) on the heat dissipation base can be fastened by the screws to the electric heat generating components of the computer, wherein, the four sides of the said heat dissipation base (10) are folded upwards to form four side walls (12) and a receiving slot (13) at the center for mounting the fan (20); the four side walls (12) are not connected to each other but have four open corners, the top ends whereon extend parallel to the both sides with convex blocks (121) to be interlocked with the interlock hooks (321) at the bottom end of the interlock poles (32) on the cover (30); furthermore, there are air outlets (14) set respectively on the four side walls (12); a plurality of conduct current partitions (15) are formed by cutting with proper width and folding upwards the base plate (11) connected with the air outlets (14); the cut planes of the conduct current partitions are set at different angles according to the rotating directions of the fan (20) to form proper wing channels to destroy the whirling wind walls produced by the air current induction of the fan (20) in operation, thus to allow the air current to be circulated smoothly by the conduction of the conduct current boards (15) and at the same time, the included angles formed by the conduct current boards (15) can reduce the area of the flowing field, increase the wind pressure moving towards the air outlets (14) and diffuse the hot air rapidly towards the air outlets (14) without causing the standstill phenomenon but the hot sources absorbed by the base plate can also be diffused rapidly towards the air outlets (14) through the wind channels to achieve the maximum heat dissipation efficiency; the fan (20) is pivotally mounted between the cover (30) and the heat dissipation base (10); the air inlets (31) are set on the top plane of the cover (30) with interlock poles (32) formed downwardly and respectively at the two diagonal angles on the bottom plane; furthermore, the interlock hooks (321) protrude outwards from the bottom ends of the interlock poles (32) to interlock with the convex blocks (121) on the side walls (12) of the heat dissipation base (10).

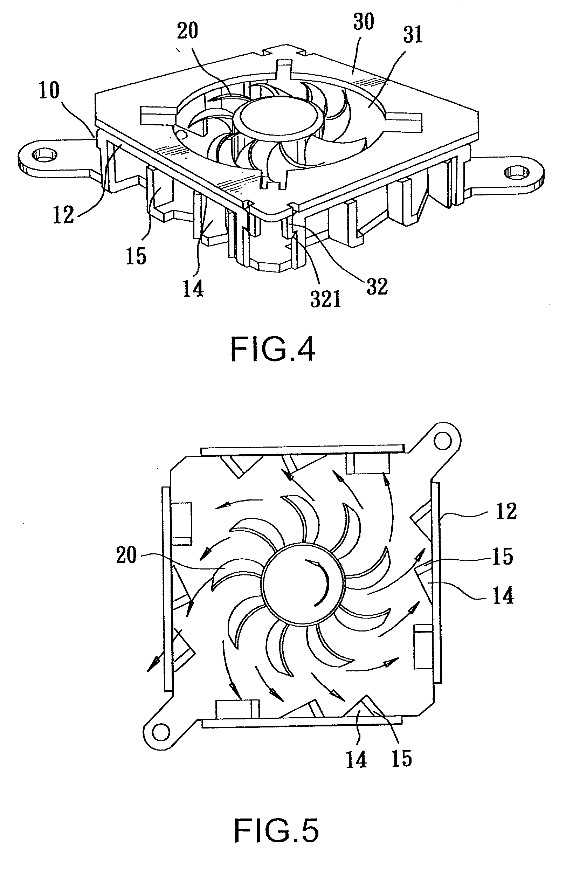

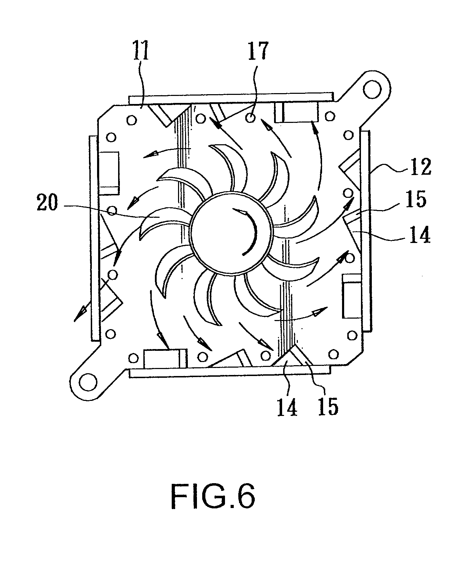

Referring to FIGs. 4 and 5, the pictorial drawing of the assembled invention herein and the isometric drawing of the wind conduction, as the fan (20) starts to run and transmit the blowing air current towards the four side walls (12), through the conduct current partitions (15), conduct the air current to the air outlets (14); since the included angles formed by the conduct current partitions are set according to the directions of the whirling wind channels of the fan (20) to avoid the reflection and collision of the air current to produce the reverse current phenomenon, therefore, the conduct current partitions (15) can interference the air current from flowing reversely, the included angles formed thereby can reduce the area of flowing field and relatively increase the flowing speed of the air current to enable the circulation become more smoothly and the heat energy can be diffused continuously and rapidly.

Referring to FIG. 6, the another isometric drawing of the invention herein in preferred embodiment, through the function of the heat accumulation of the heat dissipation convex spots (17) set in front of the air outlets (14) on the base plate (11), the heat generated by the electric heat generating components of the computer can be collected; the heat dissipation convex spots (17) are also set within the wind channels formed by the conduct current partitions (15) to increase the contact between the air current conducted by the conduct current partitions (15) and the heat dissipation convex spots (17), furthermore, to rapidly diffuse the heat sources absorbed by the heat dissipation convex spots (17) through the wind channels formed by the conduct current partitions (15) towards the air outlets (14).

One special feature worthy of mention is that the heat dissipation base can be molded by punch press, not only increasing the speed of production, but also utilizing the spatial area to the maximum without wasting the materials, therefore tremendously reduce the costs of exploitation.

However, the terminology utilized for the said drawings and components have been selected to facilitate the description of the invention herein and shall not be construed as a limitation on the patented scope and claims of the invention herein and, furthermore, all substitutions of equivalent components by persons skilled in the relevant technology based on the spirit of the invention herein shall still be regarded as within the protected scope and claims of the new patent rights granted the invention herein.

In summation of the foregoing section, the improved "Heat Dissipation Structure" is an invention of reasonable perfection that not only possesses outstanding practicality, but has an unprecedented structural spatial design that is original and innovative and, manifestly accelerates the rate of heat dissipation and specifically enhances the heat dissipation efficiency, is a solution to the height characteristics of inventions based on the conventional technology and, furthermore, is progressive and not a conception based merely on familiarity of utilization; therefore, the invention herein fully complies with all new patent application requirements and hereby sincerely submitted to the patent bureau for review and the grating of the commensurate patent rights.

## Claims

1. An improved heat dissipation structure mainly comprises of a heat dissipation
base with four sides folded upwards to form four side walls with a receiving slot at the center and convex blocks protruded respectively on the top ends of the four side walls parallel to the both sides to be interlocked to the interlock hooks at the bottom ends of the interlock poles of the cover; a pivotally running fan mounted within the cover can be installed in the receiving slot; furthermore, a cover with air inlets on the top plane and downward interlock poles formed respectively at the two diagonal angles on the bottom plane; the interlock hooks protruded from the bottom ends of the interlock poles can be interlocked to the top of the heat dissipation base, is **characterized** of:
Air outlets are set on the four side walls; the base plate connected with the air outlets is cut respectively with proper width and folded upwards to form a plurality of conduct current partitions; the cut planes of the conduct current partitions are in different corresponding angles according to the rotating direction of the fan thus to form proper wind channels.

2. As mentioned in Claim 1 of the improved heat dissipation structure invention herein, there are heat dissipation convex spots set both in front of the said air outlets of the base plate and within the wind channels formed by the conduct current partitions.
